(19) Europäisches Patentamt
European Patent Office
Office européen des brevets

(11) Veröffentlichungsnummer: **0 132 677**
**A1**

(12) # EUROPÄISCHE PATENTANMELDUNG

(21) Anmeldenummer: 84107998.1

(22) Anmeldetag: 09.07.84

(51) Int. Cl.⁴: **C 23 C 18/04**
C 23 C 18/06, C 23 C 18/54
C 23 C 22/78, B 05 D 1/02
H 05 K 3/14, H 01 L 21/285

(30) Priorität: 22.07.83 DE 3326508

(43) Veröffentlichungstag der Anmeldung:
13.02.85 Patentblatt 85/7

(84) Benannte Vertragsstaaten:
AT CH DE FR GB IT LI NL SE

(71) Anmelder: BAYER AG
Konzernverwaltung RP Patentabteilung
D-5090 Leverkusen 1 Bayerwerk(DE)

(72) Erfinder: von Gizycki, Ulrich, Dr.
Wiembachallee 24
D-5090 Leverkusen 3(DE)

(72) Erfinder: Wolf, Gerhard Dieter, Dr.
Wilhelm-Busch-Strasse 29
D-4047 Dormagen(DE)

(72) Erfinder: Sirinyan, Kirkor, Dr.
Humperdinckstrasse 12
D-5060 Bergisch-Gladbach 2(DE)

(54) **Verfahren zum Aktivieren von Substratoberflächen für die direkte partielle Metallisierung von Trägermaterialien.**

(57) Metallisierte Substratoberflächen, insbesondere Leiterplatten für gedruckte Schaltungen erhält man in vorteilhafter Weise, indem man in organischen Lösungsmitteln homogen verteilte metallorganische Verbindungen von Elementen der 1. und 8. Nebengruppe des Periodischen Systems nach "Ink-mist"- oder "Inkjet"-Verfahren auf die Trägerplatten aufbringt und die so vorbehandelten Substrate nach einer Sensibilisierung unmittelbar in ein stromloses Metallisierungsbad einbringt.

EP 0 132 677 A1

BAYER AKTIENGESELLSCHAFT 5090 Leverkusen, Bayerwerk

Konzernverwaltung RP
Patentabteilung K/ABc

# Verfahren zum Aktivieren von Substratoberflächen für die direkte partielle Metallisierung von Trägermaterialien

Die Erfindung betrifft ein Verfahren zum Aktivieren der Oberflächen von Trägermaterialien, die direkt der partiellen stromlosen Metallisierung unterworfen werden können, beispielsweise zum Zwecke der Herstellung von Leiterplatten für gedruckte Schaltungen.

Derartige Leiterplatten können nach einer Vielzahl von Verfahrensvarianten hergestellt werden. Je nach Art der Metallauflage unterscheidet man dabei das Semiadditiv-, Volladditiv-, Metallresist- und Substraktiv-Additiv-Verfahren sowie die sogenannte "Multilayer-Technik" (vgl. Günther Hermann "Leitplatten Herstellung und Vorbehandlung", Eugen G. Lenze Verlag, Saulgau/Württ. 1978).

Bei den Substraktiv-Verfahren wird die Trägerplatte mit einer Cu-Folie beidseitig kaschiert, beispielsweise mit einem Siebdruck- oder Photolack partiell beschichtet, die

lackfreie Cu-Auflage mit Oxidantien wie $FeCl_3$ ausgeätzt, gespült, mit einer Aktivator-Lösung aktiviert, gespült, sensibilisiert und dann in einem chemischen Metallisierungsbad durchkontaktiert.

Die Additiv-Verfahren, welche zum direkten Aufbau von Leiterplatten führen, sind durch folgende Arbeitsschritte gekennzeichnet,

Beschichten des Trägers mit einem Haftvermittlerlack, Ätzen der Lackschicht mit Chromschewefelsäure, Aktivieren der Lackschicht mit einer Aktivator-Lösung, Beschichten der Substratoberfläche mit z.B. einem Siebdruck- oder Photolack, partielles Entwickeln der neuen Lackschicht, Sensibilisieren, chemisches Vernickeln oder Verkupfern und galvanisches Verstärken der elektrisch leitenden Metallauflage.

Als Aktivator-Lösung werden dabei vorzugsweise ionogene oder kolloidale Palladiumlösungen sowie neuerdings auch Lösungen oder Dispersionen von metallorganischen Verbindungen (vgl. AT-B 286 058, DE-A 2 451 217 und DE-A 3 123 946) eingesetzt.

Aus der vorstehend gegebenen kurzen Beschreibung der bekannten Verfahren zur partiellen Metallisierung von Substraten wird ersichtlich, daß diese sehr arbeitsintensiv sind. Auch sind sie zumeist nicht in der Lage, die gewünschten feinen elektrischen Leiterbahnen, die einen komplizierten geometrischen Aufbau in µm-Bereich aufweisen, zu erzeugen und führen zu einer nicht reversiblen Verschlechterung des Basismaterials.

Darüber hinaus verursachen die bei wäßrigen Metallisierungsverfahren eingeschleppten Oxidantien, wie z.B. Chromationen, eine irreversible Vergiftung der Aktivierungs-, Sensibilisierungs- und Metallisierungsbäder.

Der vorliegenden Erfindung liegt nun die Aufgabe zugrunde, diese Nachteile zu vermeiden und insbesondere Träger mit einer partiellen Metallauflage zu versehen, wobei eine übliche Nach- oder Vorbehandlung des Trägers, wie Aufbringen einer Maske, chemisches oder physikalisches Entfernen der Maske oder partielles Ausätzen der durchgehenden Metallauflage, nicht erforderlich ist.

Diese Aufgabe wird erfindungsgemäß dadurch gelöst, daß man als Aktivator eine in einem organischen Lösungsmittel homogen verteilte metallorganische Verbindung von Elementen der 1. und 8. Nebengruppe des Periodensystems verwendet und diese partiell nach einem selektiv gesteuerten Sprühnebel-Aufzeichnungsverfahren, insbesondere dem "Ink-mist"- oder "Ink-jet"-Verfahren, auf die Substratoberfläche aufbringt.

Das "Ink-jet"-Aufzeichnungsverfahren ist allgemein bekannt. Hierbei handelt es sich um ein Tintendruckverfahren, bei dem Flüssigkeitströpfchen unter Steuerung auf eine Trägeroberfläche gespritzt werden, ohne daß der

Druckkopf mit der Trägeroberfläche in Berührung kommt. Ein solches Verfahren ist beispielsweise in der Siemens-Zeitschrift Heft 4, April 1977, Seiten 219 bis 221 beschrieben.

Mit diesem Verfahren ist ein sehr schnelles Drucken von Informationen auf Aufzeichnungsmaterialien auf der Basis von Zellulose möglich.

Zur Steuerung der Schreibdüsen und damit verbundene Auslösung eines Tröpfchenausstoßes wird vornehmlich der piezoelektrische Effekt ausgenützt. Ein nach diesem Prinzip arbeitender Schreibkopf ist beispielsweise in der DE-OS 25 43 457 angegeben.

Im Gegensatz zum "Ink-jet"-Verfahren, bei dem die Drucktinte durch eine zwischen den Düsen und einer gegenüberliegenden Elektrode angelegte Signalspannung beschleunigt bzw. gesteuert wird, wird bei dem ebenfalls an sich bekannten "Ink-mist"-Verfahren ein Druckfarbennebel durch Ultraschall-Oszillation erzeugt.

Die metallorganischen Aktivatoren für die stromlose Metallisierung von Substratoberflächen sind gleichfalls allgemein bekannt (vgl. außer der oben zitierten AT-B 286 058 und DE-A 24 51 217 auch DE-A 3 025 307, DE-A 3 148 280 und DE-A 3 150 985).

Es handelt sich dabei um Metall-Chelat-Komplexe, metallorganische $\pi$-Verbindungen, die über die zur Metallbindung erforderliche Gruppe hinaus mindestens eine weitere

funktionelle Gruppe enthalten, sowie oligomere, polymere und präpolymere metallorganische Verbindungen.

Bevorzugt sind organometallische π-Verbindungen der Elemente Pd, Au, Pt, Ag. Beispielsweise seien Butadienpalladiumdichlorid, Isoprenpalladiumdichlorid und Benzonitrilpalladiumdichlorid genannt.

Besonders bevorzugt sind die ebenfalls zum Teil bekannten bzw. nach an sich bekannten Verfahren erhältlichen Komplexverbindungen der Elemente der 1. und 8. Nebengruppe des Periodensystems in den Oxidationsstufen 1-4 (insbesondere einwertiges Palladium) mit ungesättigten Ketonen der Formel

$$R_1 - \underset{\substack{\| \\ O}}{C} - \underset{\substack{| \\ R_2}}{C} = \underset{\substack{| \\ R_3}}{C} - R_4$$

worin

$R_1$ und $R_4$ $C_1$-$C_{20}$-Alkyl, vorzugsweise $C_1$-$C_6$-Alkyl, $R_2$ und $R_3$ Wasserstoff oder $C_1$-$C_4$-Alkyl, vorzugsweise Methyl bedeuten.

Beispielhaft seien genannt: Mesityloxid, n-Buten-3-on-2, n-Hepten-3-on-2, n-Hexen-3-on-2, n-Decen-4-on-3, 5-Chlor-penten-3-on-2, Ethylvinylketon, 3-Methyl-octen-5-on-4, 3-Methyl-penten-3-on-2, 7-Methoxy-hepten-3-on-2.

Komplexe, die sich von diesen Verbindungen ableiten, zeichnen sich durch hohe Lagerstabilität aus.

Als organische Lösungemitel zur homogenen Verteilung der Aktivatoren sind Methylenchlorid, Chloroform, Mesityloxid, Trichlorethylen, 1,1,1-Trichlorethan, Aceton, Methanol, Ethanol, Butanol, Ethylenglykol sowie Gemische mit diesen und anderen Lösungsmitteln geeignet.

Um die Haftung der Metallauflage an der Trägeroberfläche zu erhöhen, werden solche Lösungsmittel oder Lösungsmittelgemische, die zu einer Anlösung oder Anquellung der zu metallisierenden Kunststoffoberfläche führen, zu Durchführung des erfindungsgemäßen Verfahrens besonders bevorzugt eingesetzt.

In diesem Zusammenhang sei auf Lösungsmittel bzw. ihre Verschnitte mit Fällungsmitteln hingewiesen, die beispielsweise im "Polymer Handbook", Brandrup, J., Innergut, E.H., John Wiley and Sons, Inc., New York (1974) beschrieben werden.

Ohne den Umfang einzuschränken, empfiehlt sich jedoch bei der Durchführung des Verfahrens im technischen Maßstab folgende Bedingungen einzuhalten.

i Die Lösungsmittel sollen nicht zu einem irreversiblen chemischen oder physikalischen Abbau des Aktivators führen.

ii Sie sollen nicht zu einer Koagulation bzw. Entmischung des Aktivators führen.

iii Sie sollen nicht zum völligen Auflösen oder Ausätzen des eingesetzten Trägers führen.

iv Sie sollen ohne zusätzliche Nachbehandlung wie UV-Bestrahlung oder Vakuumbehandlung verdampfbar sein.

vi Um den gewünschten Viskositätsbereich bzw. rheologische Eigenschaften programmieren zu können, können selbstverständlich die Aktivierungslösungen mit organischen Polymeren und Latices und/oder organischen bzw. anorganischen Verdickungsmitteln versetzt werden. Solche Zusatzstoffe, die den organischen Lösungen Strukturviskosität, Thixotropie, dilatantes oder newtonisches Fließverhalten verleihen, sind allgemein bekannt (vgl. Ullman 7, 80; 10, 715, 740; 17, 107, 192). Bei ihrer Wahl müssen die Arbeitsbedingungen des Gerätes (Druckgeschwindigkeit, Schubspannung u. die in den Düsen herrschenden Scherkräfte bzw. Schergeschwindigkeit) bzw. die chemische und physikalische Beschaffenheit der Aktivierungslösung (beispielsweise Viskosität, Siedepunkt u. Quellungseigenschaften) berücksichtigt werden.

vii Die Aktivierungslösungen sollen eine Viskosität zwischen 0,3 und 100 cp aufweisen.

Das erfindungsgemäß neue Verfahren wird im allgemeinen folgendermaßen durchgeführt:

Eine metallorganische Verbindung von Elementen der 1. und 8. Nebengruppe des Periodensystems, insbesondere von Cu, Ag, Au, Pd und Pt wird in einem organischen Lösungsmittel gelöst. Die Konzentration der metallorganischen Verbindung soll zwischen 0,01 und 100 g pro Liter (bezogen auf eingesetztes Metall) betragen, wobei die Konzentration zwischen 0,1 - 10,0 g pro Liter bevorzugt und die zwischen 0,1 - 2,5 g pro Liter besonders bevorzugt wird.

Die Aktivierungslösung wird nach "Ink-jet"- oder "Ink-mist"-Verfahren tröpfchenförmig - z.B. bei Temperaturen von 10 bis 40°C - gegen den Träger gespritzt und dann getrocknet.

Als Träger für das erfindungsgemäße Verfahren eignen sich z.B. Papier, Polyethylen, Polypropylen, ABS-Kunststoffe, Epoxyharze, Polyamid-, Polyester-, Polyacrylnitril-Kunststoffe, Styrol-Butadien-Copolymerisate, Amid-/Imid-Cokondensate, Polyhydantoin sowie deren Mischungen oder Mischpolymerisate der genannten Monomeren.

Die so partiell aktivierten Träger müssen anschließend durch Reduktion sensibilisiert werden. Dazu können bevorzugt die in der Galvanotechnik üblichen Reduktionsmittel wie Hydrazinhydrat, Formaldehyd, Hypophosphit oder Borane verwendet werden.

Die so aktivierten Oberflächen können direkt zur stromlosen Metallisierung eingesetzt werden. Es kann aber auch erforderlich sein, die Oberflächen durch Spülen von den Reduktionsmittelresten zu befreien.

Eine ganz besonders bevorzugte Ausführungsform des erfindungsgemäßen Verfahrens besteht darin, daß die Sensibilisierung im Metallisierungsbad gleich mit dem Reduktionsmittel der stromlosen Metallisierung durchgeführt wird. Diese besonders bevorzugte Ausführungsform stellt eine bisher nicht mögliche Vereinfachung der partiellen Metallisierung dar. Diese besonders einfache Ausführungsform besteht nur noch aus den drei Arbeitsgängen: direktes partielles Aktivieren des Trägers, Verdampfen des Lösungsmittels und Eintauchen der so aktivierten Oberflächen in das Metallisierungsbad.

Diese Ausführungsform ist ganz besonders für aminboranhaltige Nickelbäder oder formalinhaltige Kupferbäder bzw. chemische Goldbäder geeignet.

Als in dem erfindungsgemäßen Verfahren einsetzbare Metallisierungsbäder kommen bevorzugt Bäder mit Ni-, Co-, Cu-, Au- und Ag-Salzen oder deren Gemische in Frage. Derartige Metallisierungsbäder sind in der Technik der stromlosen Metallisierung bekannt. Gegebenenfalls können solche Metallauflagen auf chemischen oder galvanischem Wege beliebig verstärkt werden.

Die erfindungsgemäßen Verfahrensprodukte sind vielseitig anwendbar, beispielsweise bei der Herstellung von gedruckten Schaltungen (elektrischen Leiterplatten), metallisch glänzenden Werkstoffen (für dekorative Zwecke), antistatisch bzw. gegenüber elektromagnetischen Wellen abgeschirmten Kunststoffträgern, Identitätskarten, magnetischen Informationsträgern bzw. Aufzeichnungs- und Speichermaterialien, Impuls- und Taktgebern, geheimen nach dem Bedrucken (partielles Aktivieren) nach einer gewünschten Zeit durch Metallisieren sichtbar zu machenden Informationen und mit metallisch glänzenden Buchstaben, Linien usw. versehenen Papier- oder Kunststoffträgern. Die neue Erfindung wird durch die nachfolgenden Beispiele näher erläutert, ohne deren Umfang dadurch einzuschränken.

Beispiel 1

Eine 210 x 300 mm große und 0,1 mm starke ABS-Folie wird nach dem herkömmlichen "Ink-jet"-Verfahren mit einer Aktivierungslösung, welche aus 0,75 g 4-Cyclohexen-1,2-dicarbonsäurepalladium-(II)-chlorid, 800 ml Ethanol und 50 ml Trichlorethen angesetzt wird, partiell aktiviert, 1 Minute bei Raumtemperatur getrocknet und dann 20 Minuten in einem chemischen Ni-Bad, welches in 1 l 3,0 g Dimethylaminboran, 30 g $NiCl_2$ und 10 g Citronensäure enthält und mit konz. Ammoniaklösung auf pH 8,2 eingestellt ist, stromlos vernickelt. Man bekommt eine partiell metallisierte Folie. Die Schichtdicke der metallisch glänzenden Ni-Auflage beträgt ca. 0,2 µm.

Beispiel 2

Eine 210 x 300 mm große und 0,05 mm starke Pappe aus Zellulosefasern wird nach dem herkömmlichen "Ink-mist"-Verfahren mit einer Aktivierungslösung, welche aus 0,5 g Butadienpalladiumdichlorid, 500 ml Cyclohexanol, 200 ml Ethylenglykol und 50 ml Mesityloxid angesetzt wird, partiell aktiviert, 5 Min. bei Raumtemperatur getrocknet, in einem wäßrigen Reduktionsbad, welches in 1 l 4,0 g Dimethylaminboran enthält, 3 Min. sensibilisiert und dann in einem üblichen chemischen Kupferbad (z.B. der Fa. Friedrich Blasberg GmbH & Co. KG, 5650 Solingen) verkupfert. Bereits nach 15 Minuten ist der Probekörper mit einer partiellen Cu-Auflage bedeckt. Nach ca. 25 Min.

hat die chemische Cu-Auflage eine mittlere Stärke von ca. 0,2 µm und Breite von ca. 75 µm. Nachdem der Probekörper dem chemischen Metallisierungsbad entnommen und mit destilliertem Wasser gespült worden ist, wird er in einem galvanischen Kupferbad bei 0,6 $A/dm^2$ in 30 Minuten galvanisch auf eine Stärke von ca. 6,6 µm verstärkt.

Beispiel 3

Ein 300 x 20 mm großes Rechteck aus einer Polyesterfolie wird gemäß Beispiel 1 aktiviert und nach dem Verdampfen des Lösungsmittels 15 Min. vernickelt.

Man bekommt eine partiell metallisierte Folie. Die Schichtdicke der metallisch glänzenden Ni-Auflage beträgt ca. 0,2 µm.

Beispiel 4

Ein 100 x 100 mm großes Quadrat einer glasfaserverstärkten Polyamidfolie wird mit einer Lösung von 0,6 g Acetonitrilpalladiumdichlorid in 1 l 1,1,1-Trichlorethan nach "Ink-mist"-Verfahren partiell aktiviert und dann nach Beispiel 1 stromlos metallisiert. Bereits nach 30 Sek. beginnt sich die Oberfläche der Platte partiell dunkel zu färben, nach 3 Min. ist sie mit einer feinen Ni-Auflage partiell bedeckt. Nach ca. 15 Min. hat die chemisch abgeschiedene Ni-Auflage eine Stärke von ca. 0,2 µm und eine Breite von ca. 25 µm. Ähnliche Effekte werden bei Verwendung des Palladium-I-Komplexes von n-Hepten-3-on erzielt.

Beispiel 5

Ein 200 x 200 mm großes Quadrat einer glasfaserverstärkten Polyesterfolie wird mit einer Lösung, welche aus 0,9 g Isoprenpalladiumdichlorid, 2 g kationischem Polyurethanlatex, 200 ml Methanol und 400 ml Methylenchlorid angesetzt wird und eine Viskosität von 5,0 cp aufweist, nach Beispiel 2 aktiviert, getrocknet, sensibilisiert und dann 25 Min. verkupfert.

Man bekommt ein partiell metallisiertes Kunststoffteil, welches in einem herkömmlichen galvanischen Goldbad (z.B. der Fa. Blasberg GmbH & Co. KG, 5650 Solingen) auf eine Stärke von ca. 40 µm vergoldet wird.

Beispiel 6

Der Heptenon-Komplex gemäß Beispiel 4 wird wie folgt hergestellt:

6 g wäßrige $Na_2PdCl_4$-Lösung, welche 15 Gew.-% Pd enthält, werden bei 110°C in 15 Minuten 20 g frisch destilliertes n-3-Hepten-2-on zugetropft, 25 Minuten bei der o.a. Temperatur gerührt, dann auf 0°C abgekühlt. Nach zwei Stunden wird der gelbe Niederschlag abgesaugt, 3 x je mit 75 ml destilliertem Wasser und dann 2 x mit je 50 ml nachgereinigtem kaltem Ethanol gewaschen, getrocknet, aus Toluol/Trichlorethylen (1:1) umkristallisiert, im Trockenschrank unter Vakuum über Nacht getrocknet. Man erhält mit 92 %iger Ausbeute einen pink-gelben kristallinen Feststoff vom Zersetzungspunkt 188°C.

## Patentansprüche

1. Verfahren zum Aktivieren von Substratoberflächen für die direkte partielle stromlose Metallisierung von Trägermaterialien mit Hilfe von in organischen Lösungsmitteln homogen verteilten metallorganischen Verbindungen von Elementen der 1. und 8. Nebengruppe des Periodischen Systems, dadurch gekennzeichnet, daß man diese Verbindungen nach einem selektiv gesteuerten Sprühnebelaufzeichnungsverfahren, insbesondere dem "Ink-mist"- oder "Ink-jet"-Verfahren, aufbringt.

2. Verfahren nach Anspruch 1, dadurch gekennzeichnet, daß man die so vorbehandelten Substrate nach Entfernung des Lösungsmittels und gegebenenfalls nach einer Sensibilisierung unmittelbar in ein stromloses Metallisierungsbad einbringt.

3. Verfahren nach Anspruch 1, dadurch gekennzeichnet, daß man die Aktivierung mit metallorganischen $\pi$-Verbindungen oder Chelatkomplexen der Elemente Au, Ag, Pd, Pt und Cu durchgeführt.

4. Verfahren nach Anspruch 1, dadurch gekennzeichnet, daß die metallorganischen Verbindungen über die zur Metallbindung erforderliche Gruppe hinaus wenigstens eine weitere funktionelle Gruppe aufweist.

5. Verfahren nach Anspruch 1, dadurch gekennzeichnet, daß man die Aktivierung mit Komplexverbindungen von ungesättigten Ketonen der Formel

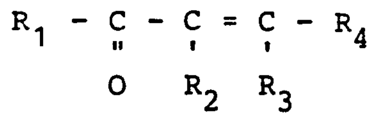

worin

$R_1$ und $R_4$ $C_1$-$C_{20}$-Alkyl, vorzugsweise $C_1$-$C_6$-Alkyl, $R_2$ und $R_3$ Wasserstoff oder $C_1$-$C_4$-Alkyl, vorzugsweise Methyl, bedeuten,

durchführt.

6. Verfahren nach Anspruch 1, dadurch gekennzeichnet, daß man die Aktivierung mit dem Palladium-I-Komplex von Buten-3-on-2 durchführt.

7. Verfahren nach Anspruch 1, dadurch gekennzeichnet, daß die organometallische Verbindung in dem Lösungsmittel in einer Menge von 0,1 bis 100,0 g/l (bezogen auf eingesetztes Metall) gelöst oder dispergiert vorliegt.

8. Verfahren nach Anspruch 1, dadurch gekennzeichnet, daß als chemische Metallisierungsbäder Cu, Ni, Co, Au bzw. deren Mischungen untereinander eingesetzt werden.

9. Verfahren nach Anspruch 1, dadurch gekennzeichnet, daß man dieses zur Herstellung von Leiterplatten verwendet.

Europäisches Patentamt

**0132677**
Nummer der Anmeldung

# EUROPÄISCHER RECHERCHENBERICHT

EP 84107998.1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 4) |
|---|---|---|---|
| Y | DE - A - 2 253 944 (AGFA-GEVAERT AG)<br>* Seiten 1-4; Ansprüche *<br>-- | 1 | C 23 C 18/04<br>C 23 C 18/06<br>C 23 C 18/54<br>C 23 C 22/78<br>B 05 D 1/02<br>H 05 K 3/14<br>H 01 L 21/285 |
| D,Y | DE - A1 - 3 148 280 (BAYER AG)<br>* Ansprüche; Beispiele; Seite 7, Zeilen 23-28 *<br>-- | 1,3,4,7,8 | |
| Y | DE - B2 - 2 731 894 (R. KRAUS)<br>* Spalte 4, Zeile 21 - Spalte 5, Zeile 62 *<br>-- | 1 | |
| D,Y | DE - A1 - 2 451 217 (BASF AG)<br>* Ansprüche *<br>-- | 1,3,4 | **RECHERCHIERTE SACHGEBIETE (Int. Cl.4)** |
| A | DE - A1 - 2 947 357 (OUTOKUMPU OY)<br>* Ansprüche *<br>-- | 1 | C 23 C<br>B 05 D<br>H 05 K |
| A | CH - A5 - 616 178 (ELECTROPLATING ENGINEERS OF JAPAN, LTD.)<br>* Zusammenfassung; Ansprüche *<br>---- | 1,9 | H 01 L |

Der vorliegende Recherchenbericht wurde für alle Patentansprüche erstellt.

| Recherchenort | Abschlußdatum der Recherche | Prüfer |
|---|---|---|
| WIEN | 26-09-1984 | SLAMA |

**KATEGORIE DER GENANNTEN DOKUMENTEN**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82